# EUROPEAN PATENT APPLICATION

(11) **EP 1 602 750 A1**
(43) Date of publication of application: **07.12.2005**
(21) Application number: 04702436.9
(22) Date of filing: 15.01.2004
(51) Int. Cl.: C25D 7/00, C23C 18/31, C23C 28/02, H05K 7/20, H01L 23/36, F28D 1/03, G12B 15/06

(54) **SURFACE-TREATED Al SHEET EXCELLENT IN SOLDERABILITY, HEAT SINK USING THE SAME, AND METHOD FOR PRODUCING SURFACE-TREATED Al SHEET EXCELLENT IN SOLDERABILITY**

(30) Priority: 26.02.2003 JP 2003049689
(71) Applicant: Toyo Kohan Co., Ltd., Tokyo 102-8447 (JP)
(72) Inventor: HAYASHIDA, Takahiro, c/o TOYO KOHAN CO., LTD, Kudamatsu-shi, Yamaguchi 7448611 (JP); TSURUDA, Tomoyuki, c/o TOYO KOHAN CO., LTD., Kudamatsu-shi, Yamaguchi 7448611 (JP); KOMAI, Masao, c/o TOYO KOHAN CO., LTD., Kudamatsu-shi, Yamaguchi 7448611 (JP)
(74) Representative: Vossius & Partner
(86) International application number: PCT/JP2004/000222
(87) International publication number: WO 2004/076724

(57) **Abstract**

A surface-treated Al sheet that has excellent adhesion with a plating layer, solder wettability, and soldering strength, and can be preferably used for a heat sink which has excellent heat radiation and can be soldered; a heat sink using the Al sheet; and a method for manufacturing the surface-treated Al sheet at low cost are intended to be provided. A Zn layer is formed on a surface of an Al substrate, and a Ni layer and a Sn layer are formed by plating by displacement plating thereon, or a layer which has a solder flux property and improves thermal emission is further formed on the surface-treated Al sheet.

## Description

### Technical Field

The invention relates to a surface-treated Al sheet, particularly relates to a surface-treated Al sheet which has excellent solder wettability or soldering strength, and has large heat conductivity or thermal emissivity, and can be preferably used for a heat sink that can be soldered and is required to have excellent heat radiation; a heat sink using the sheet; and a method for manufacturing the surface-treated Al sheet.

### Background Art

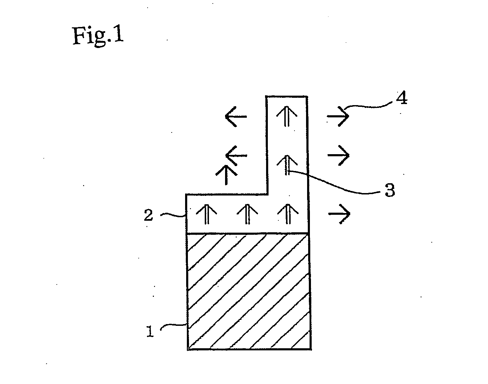

With size reduction or improvement in density of an electronic device, control of temperature rise of a component, which is equipped in a narrow inside of a chassis or substantially without clearance, becomes more necessary. In a printed circuit board, to suppress temperature rise of a component, a substrate attached with a heat sink for heat radiation is used. For example, as shown in Fig.1, the heat sink is adherently provided on at least one side of a heating element 1 such as printed circuit board. Heat conduction becomes larger with larger adhesion area. As a material for use in the heat sink, a material having excellent heat conductance is preferably used so that heat can be quickly absorbed from the heating element. As shown in Fig.1, since a heat sink 2 is placed with being extended to an area distant from the heating element 1, and heat is radiated from the extended portion, a surface of the heat sink preferably has excellent thermal emission. In Fig. 1, an arrow 3 indicates a direction of heat conduction, and an arrow 4 indicates a direction of heat emission.

In the case of a heat sink comprising a steel-sheet-based material, the heat sink can be joined to the printed circuit board by direct soldering. When a further heat radiation is required, a material based on Al having more excellent heat conductance than that of steel sheet is preferably used as a heat sink. However, since the heat sink is hard to be joined to the printed circuit board by direct soldering, a special pin is attached to the Al-based heat sink, and the heat sink is soldered to the printed circuit board via the pin. When a heat sink is joined via such a pin, a robust adhesion can not be obtained between the pin and the heat sink, in addition, since an area where the heat sink is directly adhered to the printed circuit board is reduced, heat conductance is reduced, and characteristics of Al having high heat conductance are not sufficiently utilized. Therefore, the following have been attempted to obtain an Al sheet having good solderability.

For example, JP-A-05-345969 discloses an Al-based alloy metal sheet having excellent solderability and plating adhesion, in which a Sn plating layer is formed on an Al sheet or an Al-based alloy metal material via a Ni-based plating layer. In the Al-based alloy metal sheet, a substrate such as a hot dip Al-plated steel sheet is subjected to Ni plating using vacuum deposition, subsequently subjected to Sn plating. In the case according to the method, the vacuum deposition is used for the Ni and Sn plating, and large-scale equipment such as vacuum equipment is needed, in addition, a deposition rate is small and thus productivity is low, therefore, the sheet is hard to be manufactured at low cost.

JP-A-09-291394 discloses an aluminum material coated with a tin or tin alloy layer having excellent solderability characterized in that the tin or tin alloy layer is coated on an aluminum substrate with a tin-concentration gradient layer being formed at an interface between the aluminum substrate and the tin or tin alloy layer. In the aluminum material, an aluminum alloy sheet is electroplated with tin and then heated, or the aluminum alloy sheet is run through melted tin alloy, thereby the sheet is tinned with the tin-concentration gradient layer being formed at an interface between the aluminum substrate and the tin or tin alloy layer, however, the material has a disadvantage that adhesion between the aluminum substrate and the tinning layer is insufficient, and particularly when bending is performed, a tinning film is easily separated from the aluminum substrate.

The invention intends to provide a surface-treated Al sheet which has excellent adhesion with a plating layer, solder wettability, and soldering strength, and large heat conductivity or thermal emissivity, and can be preferably used for a heat sink that can be soldered and has excellent heat emission; a heat sink using the sheet; and a method for manufacturing the surface-treated Al sheet at low cost.

### Disclosure of the Invention

A surface-treated Al sheet of the invention for achieving the object is characterized in that a Zn layer, Ni layer and Sn layer are sequentially formed on a surface of an Al substrate from a substrate surface side. The A1 substrate is not limited to a pure Al sheet, and may be an Al alloy sheet. In the surface-treated Al sheet, it is desirable that the Zn layer is provided at a coating level of 5 to 500 mg/m², and a layer for improving heat emission is further formed on the Sn layer.

A heat sink of the invention for achieving the object is characterized in that it is formed using the surface-treated Al sheet in which the Zn layer, Ni layer, and Sn layer are sequentially formed on the surface of the Al substrate from a substrate surface side, or a surface-treated Al sheet where the Zn layer is provided at the coating level of 5 to 500 mg/m² in the above surface-treated Al sheet, wherein heat conductivity is desirably 60 W/m•K or more.

Alternatively, another heat sink of the invention is characterized in that it is formed using a surface-treated Al sheet where a layer for improving heat emission is further formed on the Sn layer of the surface-treated Al sheet, wherein heat emmisivity is desirably 0.2 to 0.9.

Furthermore, a method for manufacturing the surface-treated Al sheet of the invention is characterized in that an Al substrate is subjected to displacement plating of Zn, then subjected to Ni plating, and then subjected to Sn plating;
wherein it is desirable that a layer for improving thermal emission is further formed after the Sn plating. The layer for improving thermal emission can be formed by, for example, coating and drying aqueous resin containing black pigment and aqueous rosin on the surface-treated Al sheet.

### Brief Description of the Drawings

Fig.1 is a schematic diagram showing an example of a joining condition between a heat sink and a heating element.

### Best Mode for Carrying Out the Invention

Hereinafter, the invention is described in detail.

As an Al sheet that is a substrate of a surface-treated Al sheet of the invention, a pure Al sheet and any of Al alloy sheets of 1000 series, 2000 series, 3000 series, 5000 series, 6000 series and 7000 series of JIS standard can be used. The Al alloy sheets are degreased, then subj ected to acid etching, and then subjected to desmutting, and then subjected to displacement plating of Zn. The displacement plating of Zn is performed through steps of dipping in nitric acid treatment, first Zn substitution treatment, zinc-nitrate separation treatment, and second zinc substitution treatment. In this case, rinsing is performed after the treatment in each step. Since the Zn layer formed by the first Zn substitution treatment and the second Zn substitution treatment slightly dissolves when Ni plating is performed after the substitution treatment, a coating level of the Zn layer is preferably 5 to 500 mg/m² in a condition after Ni plating, and more preferably 30 to 300 mg/m². The coating level is adjusted by appropriately selecting concentration of Zn ions in a processing liquid and dipping time in the processing liquid in the second Zn substitution treatment. When the coating level is less than 5 mg/m², adhesion with a Ni plating layer formed on the Zn layer is insufficient, and the plating layer is easily separated when bending is performed. On the other hand, when the coating level is more than 500 mg/m², Ni plating becomes uneven, resulting in reduction in soldering strength.

Next, a Ni layer is plated on the Zn layer formed in this way. The Ni plating layer may be formed using either of electroplating and electroless plating. When the electroless plating is used, since a P compound or a B compound is used as a deoxidizer, a Ni plating film is formed as a film comprising a Ni-P alloy or a Ni-B alloy, however similarly to a film comprising pure nickel formed by the electroplating, excellent adhesion of the plating film to the Al substrate, excellent solder wettability and soldering strength are obtained. The Ni layer obtained in this way preferably has a coating level of 0.2 to 50 g/m², and more preferably 1 to 10 g/m². When the coating level is less than 0.2 g/m², since the Ni layer can not evenly cover the entire surface of the Zn layer, sufficient soldering strength can not be obtained. On the other hand, when the coating level is more than 50 g/m², effects of improving solder wettability and soldering strength are saturated, causing disadvantage in cost.

Next, a Sn layer is plated on the Ni layer. The Sn plating layer may be formed using either plating method of electroplating and electroless plating. The Sn layer preferably has a coating level of 0.2 to 20 g/m², and more preferably 1 to 10 g/m². When the coating level is less than 0.2 g/m², solder is hard to be wetted when inactive flux is used. On the other hand, when the coating level is more than 20 g/m², effects of improving solder wettability and soldering strength are saturated, causing disadvantage in cost. The Zn layer, Ni layer and Sn layer are formed on the Al sheet in this way, thereby the surface-treated Al sheet of the invention is obtained. Moreover, the surface-treated Al sheet is heated in such a degree that the uppermost Sn layer on the Al sheet is not entirely lost by alloying with the underlying Ni layer or Al substrate and free Sn is remained, so that the Al substrate and Zn layer, the Zn layer and Ni layer, and the Ni layer and Sn layer are diffused into each other, or the Al substrate, Zn layer, and Ni layer, and the Zn layer, Ni layer, and Sn layer are diffused into one another, thereby adhesion strength between the Al substrate and the plating layers, and adhesion strength among respective plating layers can be improved.

While the surface-treated Al sheet of the invention has a heat conductivity of 60 W/m•K or more, and can preferably absorb heat from a heating element and radiate the heat as a heat sink having excellent heat conductance, a layer for improving thermal emission is provided on the Sn layer, thereby heat radiation can be further improved. Although thermal emissivity of the surface-treated Al sheet of the invention is about 0.05 to 0.1, the thermal emissivity can be improved to about 0.2 to 0.9 by providing the layer for improving thermal emission. The layer for improving thermal emission is formed on the Sn layer as follows. Thus, on a surface-treated Al sheet on which the Zn layer, Ni layer and Sn layer are sequentially formed, or on a surface-treated Al sheet where the heating diffusion treatment is performed on the above surface-treated Al sheet, aqueous acrylic resin containing the black pigment and the aqueous rosin is coated and dried, thereby a processing film is formed. The processing film has a flux effect, and improves solder wettability. Concentration of the aqueous resin is preferably 100 to 900 g/L, and the black pigment is preferably contained at 50 percent by weight or less against solid contents of the resin in the resin. When it is contained more than 50 percent by weight, solder wettablility and soldering strength deteriorate. The thickness of the processing film after drying preferablyhas 0.05 to 10 µm. When it is less than 0.05 µm, the effect of improving heat radiation is small, and when it is more than 10 µm, heat conductance is degraded and heat radiation can not be improved. In this way, the layer for improving thermal emission is provided on the Sn layer, thereby heat radiation of the heat sink can be improved.

### Example

### (Preparation of Test Sheets)

An Al alloy sheet (JIS 5052H19, thickness of 0.5 mm), which was used as a plating substrate, was degreased in an alkaline solution, then subjected to etching in sulfate acid, and then subjected to desmutting in nitric acid, and then subjected to first Zn substitution treatment by dipping in a processing liquid containing sodium hydroxide of 150 g/L, Rochelle salt of 50 g/L, zinc oxide of 25 g/L, and ferrous chloride of 1.5 g/L, and then dipped in a nitric-acid solution of 400 g/L to remove electrolytically replaced Zn, and then subjected to second Zn substitution treatment by dipping in the same processing liquid as used in the first Zn substitution treatment. In the second Zn substitution treatment, dipping time was variously changed, and Zn-plated Al sheets on which Zn layers with coating levels as shown in Table 1 were formed were obtained.

Next, regarding the Zn-platedAl sheets, Ni-12wt% P alloy plating films were formed on the Zn layers with coating levels as shown in Table 1 by electroless plating. Next, regarding the plated Al sheets on which the Zn layers and the Ni layers are formed, Sn plating films were formed on the Ni layers with coating levels as shown in Table 1 by electroplating, thereby test sheets were formed. In some test sheets, diffusion heat treatment was performed after these plating, wherein the plates were heated to 280°C, thereby the Sn layers were melted, and the Al substrate and the plating layers were diffused into each other, and respective plating layers were diffused into one another in a degree that the uppermost free Sn was not lost. In other some test sheets, layers for improving thermal emission were formed using processing liquids having liquid compositions as shown in Table 2.

For comparison, a test sheet in which the Ni plating layer and the Sn plating layer were directly provided on the Al alloy sheet without providing the Zn displacement plating layer, a test sheet in which only the Sn plating layer was provided on the Al alloy sheet without providing the Zn displacement plating layer, and a test plate in which only the Sn plating layer was provided on a low-carbon steel sheet (thickness of 0.5 mm) were prepared.

### (Characteristic Evaluation of Test sheets)

Regarding the test sheets obtained as above, the following characteristics were evaluated.

### [Solder Wettability]

According to the meniscograph method (MIL-STD-883B), using SOLDERCHECKER (MODEL SAT-5000, manufactured by RHESCA), specimens 7 mm in width cut out from respective test materials as above were dipped in a flux (NA-200, manufactured by TAMURA KAKEN CORPORATION), the specimens applied with the flux were dipped in a solder bath (JIS Z 3282: H60A) held at 250°C to 2 mm in depth at a dipping rate of 2 mm/sec, and time to a point where solder is wetted, or Zero Cross Time was measured, and then solder wettability was evaluated according to the following standard. The standard shows that solder wettability is better with shorter time.
○○: less than 5 sec
○: 5 or more and less than 7 sec
Δ: 7 or more and less than 10 sec
×: 10 or more sec

**Table 1**

| Preparation Conditions of Test Plates | | | | | | | | |
|---|---|---|---|---|---|---|---|---|
| Specimen No. | Substrate | Plating layer | | | Diffusion heat treatment | Processing film for improving heat radiation | | classification |
| | | Zn (Mg/m²) | Ni (g/m²) | Sn (g/m²) | | type | Thickness (µm) | |
| 1 | Al sheet | - | 10 | 10 | Not | - | - | Comparative example |
| 2 | Al sheet | 1000 | 2 | 10 | Not | - | - | Comparative example |
| 3 | Al sheet | 100 | - | 5 | Not | - | - | Comparative example |
| 4 | Al sheet | 5 | 10 | 2 | Not | - | - | The invention |
| 5 | Al sheet | - | - | 10 | Not | - | - | Comparative example |
| 6 | Al sheet | 500 | 5 | 10 | Not | - | - | The invention |
| 7 | Al sheet | 70 | 15 | 0.2 | Not | - | - | The invention |
| 8 | Al sheet | 60 | 3 | 20 | Done | - | - | The invention |
| 9 | Al sheet | 280 | 8 | 4 | Not | A | 0.5 | The invention |
| 10 | Al sheet | 280 | 8 | 4 | Not | B | 0.5 | The invention |
| 11 | Al sheet | 280 | 8 | 4 | Not | C | 3.0 | The invention |
| 12 | Al sheet | 280 | 8 | 4 | Not | D | 5.2 | The invention |
| 13 | Al sheet | 200 | 10 | - | Not | - | - | Comparative example |
| 14 | Al sheet | 170 | 50 | 20 | Not | - | - | The invention |
| 15 | Al sheet | 220 | 0.2 | 10 | Not | - | - | The invention |
| 16 | Steel sheet | - | - | 5 | Not | - | - | Comparative example |

**Table 2**

| Compositions of Processing Liquids for Improving Heat Radiation | | | |
|---|---|---|---|
| Type | Composition of processing liquid for improving heat radiation | | |
| | Acrylic resin (g/L) | Aqueous rosin (g/L) | Carbon black (wt%) |
| A | 600 | 200 | - |
| B | 600 | 200 | 5 |
| C | 600 | 200 | 30 |
| D | 600 | 200 | 50 |

### [Soldering Strength]

Two cutout pieces formed by folding two specimens 7 mm wide and 50 mm long cut out from each of the test materials in an L shape were piled with evaluation surfaces being opposed to form a T shape, and a steel sheet 0.5 mm thick was interposed between vertical bar portions of the T shape, and thus a specimen where a vacant space of 0.5 mm was formed between lower parts of the vertical bars of the T shape was prepared. The same flux as used in the evaluation of solder wettability was applied in the vacant space of the specimen, and then using SOLDERCHECKER (SAT-5000, manufactured by RHESCA), the vacant space of the specimen was dipped in a solder bath (JIS Z 3282: H60A) held at 250°C to 10 mm in depth and held for 5 sec to fill solder in the vacant space and then taken out, thereby a T peel test piece was formed. Next, using TENSILON, horizontal bar portions of the T shape of the T peel test piece were pinched by a chuck and pulled, thereby the solder filling portion between the vertical bar portions of the T shape was torn, and soldering strength was measured and evaluated according to the following standard.
○○: 4 kgf/7mm or more
○: 3 or more and less than 4 kgf/7mm
Δ: 1 or more and less than 3 kgf/7mm
×: less than 1 kgf/7mm

### [Adhesion of Plating Film]

A specimen 15 mm wide and 50 mm long was cut out from each of the test materials, folded at 90 degrees, and a scotch tape was pasted to the folded portion and then peeled off, and then presence of separation of the plating film was observed with the naked eye, and adhesion of the plating film was evaluated according to the following standard.
○: separation is not observed
×: separation is observed

### [Heat Radiation]

A specimen 5 mm wide and 10 mm long was cut out from each of the test materials, and heat conductivity was measured using optical AC process thermal constants measuring system (PIT-R2, manufactured by ULVAC-RIKO, Inc.) In addition, thermal emissivity was measured using emissivity meter (D and S AERD emissivity meter, manufactured by KYOTO ELECTRONICS MANUFACTURING CO., LTD.), and heat radiation was evaluated according to the following standard.
○○: heat conductivity of 60 W/m•K or more and thermal emissivity of 0.20 or more
○: heat conductivity of 60 W/m•K or more and thermal emissivity of 0.05 or more and less than 0.20
Δ: heat conductivity of 40 or more and less than 60 W/m•K
×: heat conductivity of less than 40 W/m•K

As a result, as shown in Table 3, the surface-treated Al sheet of the invention in which the Zn layer, Ni layer and Sn layer are formed on the Al sheet has excellent solder wettability, high soldering strength, and has large heat conductivity and excellent heat radiation. Moreover, it was confirmed that the layer for improving thermal emission was provided on the Sn layer of the surface-treated Al sheet, thereby heat radiation was further improved. Therefore, the invention can be preferably used for a heat sink that can be soldered and has excellent heat radiation.

**Table 3**

| Characteristic Evaluation Results | | | | | | | |
|---|---|---|---|---|---|---|---|
| Specimen No. | Characteristic evaluation results | | | | | | classification |
| | Solder wettability | Soldering strength | Adhesion of plating film | Heat radiation | | | |
| | | | | Heat conductivity (W/m•K) | Thermal emissivity | Comprehensive evaluation of heat radiation | |
| 1 | × | × | × | 75 | 0.08 | ○ | Comparative example |
| 2 | ○○ | Δ | × | 89 | 0.09 | ○ | Comparative example |
| 3 | × | × | × | 98 | 0.07 | ○ | Comparative example |
| 4 | ○ | ○○ | ○ | 90 | 0.06 | ○ | The invention |
| 5 | × | × | × | 98 | 0.08 | ○ | Comparative example |
| 6 | ○○ | ○○ | ○ | 89 | 0.08 | ○ | The invention |
| 7 | ○○ | ○○ | ○ | 88 | 0.06 | ○ | The invention |
| 8 | ○ | ○ | ○ | 78 | 0.08 | ○ | The invention |
| 9 | ○○ | ○○ | ○ | 96 | 0.20 | ○ | The invention |
| 10 | ○○ | ○○ | ○ | 95 | 0.29 | ○○ | The invention |
| 11 | ○○ | ○○ | ○ | 96 | 0.68 | ○○ | The invention |
| 12 | ○○ | ○○ | ○ | 94 | 0.90 | ○○ | The invention |
| 13. | × | × | ○ | 92 | 0.05 | ○ | Comparative example |
| 14 | ○○ | ○ | ○ | 74 | 0.08 | ○ | The invention |
| 15 | ○○ | ○○ | ○ | 90 | 0.09 | ○ | The invention |
| 16 | ○○ | ○○ | ○ | 42 | 0.07 | Δ | Comparative example |

### Industrial Applicability

In the surface-treated Al sheet of the invention, since the Zn layer is formed on the surface of the Al substrate by displacement plating, and the Ni layer and the Sn layer are formed by plating thereon, adhesion between the Al substrate and the plating layers is excellent. Moreover, since the Sn layer is provided as the uppermost surface, excellent solder wettability, and high soldering strength are obtained. Furthermore, since the substrate is the Al sheet, heat conductivity is large, and heat radiation is excellent. Furthermore, the layer which has a soldering flux property and improves thermal emission is provided on the surface-treated Al sheet of the invention, thereby solderability is further improved and heat radiation can be improved. Therefore, the surface-treated Al sheet of the invention can be preferably used for a heat sink that can be soldered and has excellent heat radiation.

## Claims

1. A surface-treated Al sheet in which a Zn layer, Ni layer, and Sn layer are sequentially formed on a surface of an Al substrate from a substrate surface side.

2. The surface-treated Al sheet according to claim 1,
wherein the Zn layer is provided at a coating level of 5 to 500 mg/m².

3. The surface-treated Al sheet according to claim 1 or 2,
wherein a layer for improving thermal emission is further formed on the Sn layer.

4. A heat sink using the surface-treated Al sheet according to claim 1 or 2.

5. The heat sink according to claim 4, wherein heat conductivity is 60 W/m•K or more.

6. A heat sink using the surface-treated Al sheet according to claim 3.

7. The heat sink according to claim 6, wherein the thermal emission is 0.2 to 0.9.

8. A method for manufacturing a surface-treated Al sheet,
**characterized in that** an Al substrate is subjected to displacement plating of Zn, then subjected to Ni plating, and then subjected to Sn plating.

9. The method for manufacturing the surface-treated Al sheet according to claim 8, **characterized in that** after the Sn plating, a layer for improving thermal emission is further formed.

10. The method for manufacturing the surface-treated Al sheet according to claim 9, wherein the layer for improving thermal emission is formed by coating and drying aqueous resin containing black pigment and aqueous resin on the surface-treated Al sheet.
